# EUROPÄISCHE PATENTSCHRIFT

(11) **EP 2 105 043 B1**
(45) Veröffentlichungstag und Bekanntmachung des Hinweises auf die Patenterteilung: **09.02.2011**
(21) Anmeldenummer: 04798009.9
(22) Anmeldetag: 19.11.2004
(51) Int. Cl.: H05K 5/06, G01F 23/284, H05K 5/00

(54) **EXPLOSIONSGESCHÜTZTES GEHÄUSE**
EXPLOSION-RESISTANT HOUSING
BOITIER ANTIDEFLAGRANT

(30) Priorität: 16.12.2003 DE 20319489 U
(43) Veröffentlichungstag der Anmeldung: 30.09.2009
(73) Patentinhaber: KSB Aktiengesellschaft, 67227 Frankenthal (DE)
(72) Erfinder: HEBEL, Norbert, 67158 Ellerstadt (DE)
(86) Internationale Anmeldenummer: PCT/EP2004/013152
(87) Internationale Veröffentlichungsnummer: WO 2005/062687

(56) Entgegenhaltungen:
- WO-A-98/57186
- DE-U1- 9 112 371
- US-A- 5 422 494
- US-B1- 6 366 436

## Beschreibung

Die Neuerung betrifft ein explosionsgeschütztes Gehäuse nach Art einer druckfesten Kapselung mit integriertem Sichtfenster, innerhalb des Ex-Gehäuses ist mindestens eine Elektronikeinheit angeordnet und für eine von der Außenseite erfolgende Bedienung der Elektronikeinheit liegen an der Innenfläche des Sichtfensters ein oder mehrere Berührungsfelder der Elektronikeinheit und eines Displays an.

Solche Ex-Gehäuse sind häufig Bestandteil von Messgeräten, mit deren Hilfe in einer Anlage Durchflussgeschwindigkeiten oder anderen physikalische Größen eines gefährlichen Prozesses erfasst werden. Mit solchen Ex-Gehäusen ist in explosionsgefährdeten Anlagen gewährleistet, dass innerhalb des Gehäuses elektrische oder elektronische Schaltvorgänge ablaufen können, bei denen elektrische oder elektronische Bauteile als mögliche Zündquellen für in solchen Umgebungen befindliche zündfähigen Gase und Dämpfe dienen könnten.

Die Sichtfenster solcher explosionsgeschützten Gehäuse sind mit Berührungsschaltern versehen, so dass durch eine von außen stattfindende Berührung durch das Sichtfenster hindurch innerhalb des explosionsgeschützten Gehäuses eine Schaltfunktion ausgeübt wird. Dazu finden bekannte Schaltelemente in Form von Infrarotschaltern und kapazitiven Schaltern Verwendung. Damit sind innerhalb der explosionsgefährdeten Umgebung und ohne ein Öffnen des Ex-Gehäuses Bedienungsfunktionen möglich. Und in den Sichtfenstern selbst sind keine aufwendigen Abdichtungen notwendig, da diese nicht mehr durch irgendwelche Bauteile durchdrungen werden.

Aus der US 5 422 494 ist ein solches Ex-Gehäuse bekannt.

Durch den Endress + Hauser Katalog 2002, Industrielle Messtechnik, Herausgabedatum Oktober 2001, Seiten 451 ff, ist das Produkt "promass 63" bekannt, ein Durchflußmessgerät nach dem Coriolis-Messprinzip. Es ist in einem explosionsgefährdeten Bereich, auch Ex-Bereich genannt, ohne Öffnen des Gerätes von außen und durch dessen Sichtfenster hindurch mittels Berührungsfelder namens Touch Control bedienbar. Diese Art einer Bedienung ist für die explosionsgefährdeten Bereiche nach den Ex-Schutz Zulassungsklassen EEx d / EEx de IIC, Zone 1 / ATEX II2G, zulässig, womit die druckfeste Kapselung und die erhöhte Sicherheit gewährleistet ist. In einer explosionsgefährdeten Umgebung erlaubt dies eine Vor-Ort-Bedienung zur Programmierung aller Gerätefunktionen von außen, ohne Gehäuseöffnung und durch das explosionssichere Sichtfenster hindurch mit Hilfe der Berührungsfelder.

Bei der Montage solcher Ex-Gehäuse besteht die Schwierigkeit, immer eine zuverlässige Verbindung zwischen den an einem Sichtfenster anliegenden Berührungsfeldem zuverlässig zu gewährleisten. Zumal dadurch die Verbindung zu einer innerhalb des Ex-Gehäuses befindlichen elektrischen oder elektronischen Baueinheit geschaffen wird. Als besonders kritisch hat sich dies bei Ex-Gehäusen erwiesen, bei denen das Sichtfenster als ein Bestandteil eines Schraubdeckels ausgebildet ist und dieser explosionsgeschützt dichtend in das Ex-Gehäuse eingeschraubt ist.

Der Neuerung liegt daher das Problem zugrunde, für solche Ex-Gehäuse eine zuverlässige Verbindung zwischen den Berührungsfeldern und dem Sichtfenster zu gewährleisten, die unabhängig von Montageabläufen und verschiedenen Einbausituationen eine sichere Betätigung gewährleistet. Die Lösung dieses Problems sieht vor, dass die Berührungsfelder und das Display in eine Baugruppe integriert sind, dass innerhalb des Ex-Gehäuses teleskopartige Anpresselemente angeordnet sind und die Berührungsfelder und/oder Baugruppe an die Innenfläche des Sichtfensters pressen.

Die Baugruppe ist als ein an sich bekanntes, durch das Sichtfenster erkennbares Bedienungsfeld mit Anzeigen ausgebildet. Die Baugruppe verfügt über mindestens eine Leiterplatte, sowie über Berührungsfelder und ein Display, wobei diese Teile auch in eine Leiterplatte integriert sein können. Weiter ist die Baugruppe mit einer dem Sichtfenster zugewandten Oberfläche versehen, wobei es sich um einen Aufdruck oder eine Folie handeln kann, auf der Namen, Erklärungen, Bezeichnungen, Bedeutungen und dergleichen aufgebracht sind. Die innerhalb des Ex-Gehäuses befindlichen teleskopartigen Anpresselemente bewirken einen ständigen kraftschlüssigen Kontakt der Baugruppe oder einer Leiterplatte, insbesondere von den Berührungsfelder, mit der Innenfläche des Sichtfensters.

Mit dieser Lösung ist in einfachster Weise eine Montage eines solchen explosionsgeschützten Gehäuses möglich. Vor dem Verschließen eines solchen Ex-Gehäuses wird die Baugruppe in Wirkverbindung mit den teleskopartigen Anpresselementen gebracht. Das Sichtfenster wird auf das Ex-Gehäuse und/oder die Baugruppe oder die Leiterplatte aufgelegt und gegen die Kraft der Anpresselemente wird das Sichtfenster dichtend mit dem Ex-Gehäuse verbunden. Bei der Schließbewegung geben die Anpresselemente aufgrund deren teleskopartigen Ausbildung nach und die damit in Wirkverbindung stehende Baugruppe wandert während der Montagebewegung zusammen mit dem Sichtfenster entlang der teleskopartigen Anpresselemente in das Ex-Gehäuse hin. Somit ist eine permanente kraftschlüssige Anlage der Berührungsfelder an der Innenfläche des Sichtfensters und dadurch jederzeit deren problemlose Betätigung gewährleistet.

Unabhängig davon, ob das Sichtfenster Bestandteil eines Schraubrahmens ist, welches dichtend in das Ex-Gehäuse eingeschraubt wird, oder ob es Bestandteil eines anderen, auf, an oder in ein Ex-Gehäuse dichtend anzubringenden Rahmens ist, wird in jedem Fall durch die teleskopartigen Anpresselemente und deren Nachgiebigkeit eine ständige Anpressung der Berührungsfelder an die Innenfläche des Sichtfensters gewährleistet.

Ausgestaltungen sehen vor, dass die teleskopartigen Anpresselemente als elastische Elemente und dass die elastische Elemente als Zug- oder Druckfedern ausgebildet sind. Somit können sich an Standärd-Halteelementen in Form von Stehbolzen oder dergleichen, entsprechend ausgebildete Federelemente abstützten. Dazu sieht eine weitere Ausgestaltung vor, dass die teleskopartigen Anpresselemente als Führung für die Baugruppe, eine Leiterplatte und/oder die Elektronikeinheit ausgebildet sind. Die Baugruppe und/oder eine Leiterplatte ist in Führungselementen der Halteelemente geführt und in Achsrichtung verschiebbar gehalten.

Nach einer anderen Ausgestaltung ist mit der Baugruppe die Elektronikeinheit verbunden. Somit ergibt sich eine noch einfachere Montage, da nur noch ein einziges Bauelement von den teleskopartigen Anpresselementen geführt und gegen die Kraft dieser Anpresselemente im Ex-Gehäuse an der Innenfläche des Sichtfensters gehalten ist. Die Baugruppe verfügt über mindestens eine elektronische Leiterplatte und die Berührungsfelder. Damit kann auch die Elektronikeinheit verbunden sein. Der Aufbau der Baugruppe ist abhängig von einem gewählten technischen Aufbau, der innerhalb des Ex-Gehäuses anzuordnen ist..

In einfachster Weise sind die teleskopartigen Anpresselemente innerhalb des Ex-Gehäuses an einer Fläche und/oder an einer im Ex-Gehäuse befindlichen Grundplatte befestigt.

Ein Ausführungsbeispiel der Neuerung ist als Schnittzeichnung dargestellt und wird im folgenden näher beschrieben.

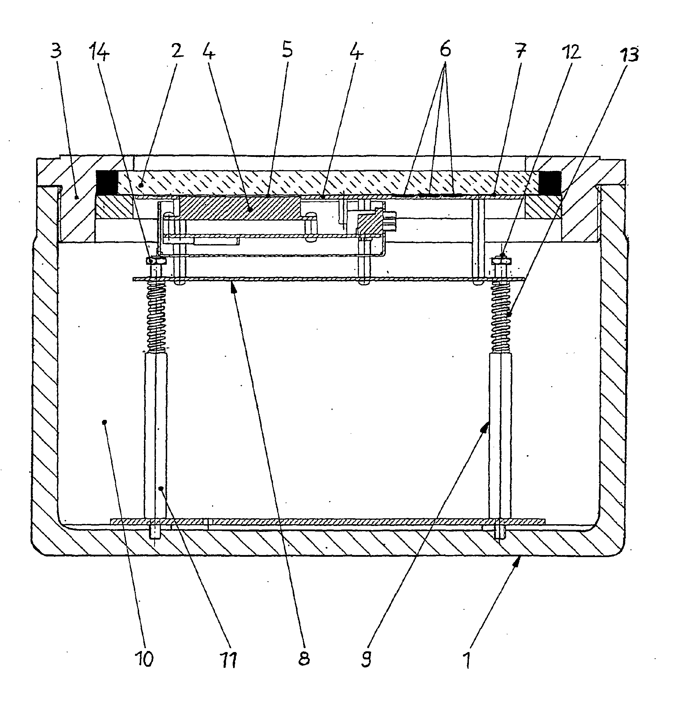

In der Figur ist im Schnitt ein explosionsgeschütztes Gehäuse 1 dargestellt. Es verfügt über ein Sichtfenster 2, welches Bestandteil eines Deckels 3 ist, der in druckfester Kapselung im Gehäuse 1 befestigt ist. Innerhalb des Gehäuses 1 befindet sich eine Elektronikeinheit 4, die mit einem Display 5 versehen ist. Die Elektronikeinheit 4 verfügt weiterhin über Berührungsfelder 6, die an der Innenfläche 5 des Sichtfensters 2 berührend anliegen. Die Berührungsfenster 6, das Display 7 und die Elektronikeinheit 4 sind Bestandteil einer Baugruppe 8. Teleskopartige Anpresselemente 9 dienen zur Halterung und Führung der Baugruppe 8 im Innenraum 10 des explosionsgeschützten Gehäuses 1.

Die teleskopartigen Anpresselemente 9 bestehen aus Halteelementen 11, die kräfteübertragend im Gehäuse 1 befestigt sind. An den Halteelementen 11 sind Führungselemente 12 angeordnet, auf denen die Baugruppe 8 geführt ist. Elastische Elemente 13, die im Ausführungsbeispiel als Druckfedern dargestellt sind, liegen an der Unterseite der Baugruppe 8 an und erzeugen eine ständige Anpresskraft in Richtung des Sichtfensters 2. Die Führungselemente 12 verfügen über Sicherungsteile 14, auf Grund derer die Baugruppe 8 an den Anpresselementen 9 gehalten ist.

Bei einer Montage wird die Elektronikeinheit 8 mit den teleskopartigen Anpresselementen 9 verbunden. Im Anschluss daran wird der Deckel 3 mit der Innenfläche 7 des Sichtfensters 2 auf die Baugruppe 8 aufgelegt und gegen die Kraft der Anpresselemente 9 wird die Baugruppe 8 bei einem Verschluss des Gehäuses 1 durch den Deckel 3 in den Innenraum des Gehäuses 1 hinein bewegt. Durch die elastischen Elemente 13 ist somit nach einem Verschluss des Gehäuses 1 ständig gewährleistet, dass die Baugruppe 8, insbesondere deren Berührungsfelder 6, unabhängig von einer Einbaulage immer berührend an der Innenfläche 7 des Sichtfensters 2 anliegen. Somit kann durch eine äußere Berührung am Sichtfenster 2 schaltend auf die Berührungsfelder 6 der Baugruppe 8 eingewirkt werden. Dadurch ist eine Einflussnahme auf die Elektronikeinheit 4 möglich, ohne dabei das explosionsgeschützte Gehäuse 1 öffnen zu müssen. Für die Berührungsfelder 6 können bekannte elektronische Bauelemente Anwendung finden, welche durch eine Glasscheibe hindurch in Folge der Änderung eines kapazitiven Widerstandes eine Schaltfunktion auszuüben vermögen.

In das Gehäuse einmündende elektrische Zuleitungen, auf deren Darstellung aus Gründen der Übersichtlichkeit verzichtet wurde, sind in an sich bekannter Art in druckfester Kapselung ausgeführt, um den entsprechenden Bestimmungen des Explosionsschutzes entsprechen zu können.

## Patentansprüche

1. Explosionsgeschütztes Gehäuse mit einer druckfesten Kapselung mit integriertem Sichtfenster, innerhalb des explosionsgeschützten Gehäuses ist mindestens eine Elektronikeinheit angeordnet und für eine äußere Einflussnahme auf die Elektronikeinheit liegen an der Innenfläche des Sichtfensters ein oder mehrere Berührungsfelder der Elektronikeinheit und ein Display an, **dadurch gekennzeichnet, dass** die Berührungsfelder (6) und das Display (5) in eine Baugruppe (8) integriert sind, dass innerhalb des explosionsgeschützten Gehäuses (1) teleskopartige Anpresselemente (9) angeordnet sind und die Berührungsfelder (6) und/oder Baugruppe (8) an die Innenfläche (7) des Sichtfensters (2) pressen.

2. Explosionsgeschütztes Gehäuse nach Anspruch 1, **dadurch gekennzeichnet, dass** die teleskopartigen Anpresselemente (9) als elastische Elemente (13) ausgebildet sind.

3. Explosionsgeschütztes Gehäuse nach Anspruch 2, **dadurch gekennzeichnet, dass** die elastischen Elemente (13) als Druck- oder Zugfedern ausgebildet sind.

4. Explosionsgeschütztes Gehäuse nach Anspruch 1, 2 oder 3, **dadurch gekennzeichnet, dass** mit der Baugruppe / Leiterplatte die Elektronikeinheit verbunden ist.

5. Explosionsgeschütztes Gehäuse nach einem der Ansprüche 1 bis 4, **dadurch gekennzeichnet, dass** die teleskopartigen Anpresselemente (9) als Führung für die Leiterplatte und/oder die Elektronikeinheit ausgebildet sind.

6. Explosionsgeschütztes Gehäuse nach einem der Ansprüche 1 bis 5, **dadurch gekennzeichnet, dass** die Anpresselemente (9) im Explosionsgeschützten Gehäuse (1) und/oder an einer im Ex-Gehäuse befindlichen Grundplatte befestigt sind.

## Claims

1. Flameproof housing having pressure-resistant encapsulation with an integrated viewing window, at least one electronics unit is arranged within the flameproof housing and one or more touch areas of the electronics unit and a display rest on the inner surface of the viewing window in order to externally influence the electronics unit, **characterized in that** the touch areas (6) and the display (5) are integrated in one assembly (8), **in that** telescopic contact-pressure elements (9) are arranged within the flameproof housing (1), and the touch areas (6) and/or assembly (8) press against the inner surface (7) of the viewing window (2).

2. Flameproof housing according to Claim 1, **characterized in that** the telescopic contact-pressure elements (9) are in the form of elastic elements (13).

3. Flameproof housing according to Claim 2, **characterized in that** the elastic elements (13) are in the form of compression or tension springs.

4. Flameproof housing according to Claim 1, 2 or 3, **characterized in that** the electronics unit is connected to the assembly/printed circuit board.

5. Flameproof housing according to one of Claims 1 to 4, **characterized in that** the telescopic contact-pressure elements (9) are in the form of guidance for the printed circuit board and/or the electronics unit.

6. Flameproof housing according to one of Claims 1 to 5, **characterized in that** the contact-pressure elements (9) are mounted in the flameproof housing (1), and/or are attached to a base plate which is located in the flameproof housing.

## Revendications

1. Boîtier antidéflagrant comprenant un blindage résistant à la pression muni d'une ouverture d'inspection intégrée, au moins une unité électronique est intégrée à l'intérieur du boîtier antidéflagrant et un ou plusieurs champs de contact de l'unité électronique ainsi qu'un afficheur reposent sur la surface intérieure de l'ouverture d'inspection pour pouvoir exercer une influence depuis l'extérieur sur l'unité électronique, **caractérisé en ce que** les champs de contact (6) et l'afficheur (5) sont intégrés dans un sous-ensemble (8), **en ce que** des éléments de pressage (9) de type télescopique sont disposés à l'intérieur du boîtier antidéflagrant (1) et les champs de contact (6) et/ou le sous-ensemble (8) s'appuient contre la surface intérieure (7) de l'ouverture d'inspection (2).

2. Boîtier antidéflagrant selon la revendication 1, **caractérisé en ce que** les éléments de pressage (9) de type télescopique sont réalisés sous la forme d'éléments élastiques (13).

3. Boîtier antidéflagrant selon la revendication 2, **caractérisé en ce que** les éléments élastiques (13) sont réalisés sous la forme de ressorts de compression ou de traction.

4. Boîtier antidéflagrant selon la revendication 1, 2 ou 3, **caractérisé en ce que** l'unité électronique est reliée avec le sous-ensemble / circuit imprimé.

5. Boîtier antidéflagrant selon l'une des revendications 1 à 4, **caractérisé en ce que** les éléments de pressage (9) de type télescopique sont réalisés sous la forme d'un guide pour le circuit imprimé et/ou l'unité électronique.

6. Boîtier antidéflagrant selon l'une des revendications 1 à 5, **caractérisé en ce que** les éléments de pressage (9) sont fixés dans le boîtier antidéflagrant (1) et/ou sur une plaque de base qui se trouve dans le boîtier antidéflagrant.
